# EUROPÄISCHE PATENTANMELDUNG

(11) **EP 1 641 126 A2**
(43) Veröffentlichungstag der Anmeldung: **29.03.2006**
(21) Anmeldenummer: 05107542.2
(22) Anmeldetag: 17.08.2005
(51) Int. Cl.: H03M 1/10

(54) **Schaltungsanordnung zum Analog/Digital-Wandeln**

(30) Priorität: 25.09.2004 DE 102004046618
(71) Anmelder: ROBERT BOSCH GMBH, 70442 Stuttgart (DE)
(72) Erfinder: Koerner, Gotthilf, 71287 Weissach (DE); Fehrenbacher, Berthold, 71706 Markgroeningen (DE); Breitmeier, Axel, 72119 Ammerbuch-Entringen (DE)

(57) **Zusammenfassung**

Die Erfindung betrifft eine Schaltungsanordnung zum Wandeln von Analogsignalen in Digitalsignale, mit einem Multiplexer (2), der eine Mehrzahl von Analogsignaleingängen(E1-E10), einen mehrere Bit breiten Adresseingang (15) und einen Ausgang (3) aufweist und eingerichtet ist, einen der Analogsignaleingänge mit dem Ausgang (3) zu verbinden, wenn eine dem betreffenden Analogsignaleingang zugeordnete Adresse an den Adresseingang (15) angelegt ist, und einem Analog/Digital-Wandler (5), dessen Eingang (4) mit dem Ausgang (3) des Multiplexers (2) verbunden ist, um das jeweils an dem Ausgang (3) ausgegebene Analogsignal zu digitalisieren. Die Schaltungsanordnung umfasst wenigstens eine Prüfsignalquelle zum Liefern eines Prüfsignals an eine Teilmenge (E2, E3, E5, E9) der Analogsignaleingänge (E1-E10) des Multiplexers (2). Außerdem ist den Analogsignaleingängen (E2, E3, E5, E9) dieser Teilmenge jeweils eine Adresse zugeordnet, von deren Bits eines einen ersten Binärwert hat und alle anderen einen von dem ersten verschiedenen zweiten Binärwert haben.

## Beschreibung

Die Erfindung betrifft eine Schaltungsanordnung zum Wandeln von Analogsignalen in Digitalsignale, mit einem Multiplexer, der eine Mehrzahl von Analogsignaleingängen, einen mehrere Bit breiten Adresseingang und einen Ausgang aufweist und eingerichtet ist, einen der Analogsignaleingänge mit dem Ausgang zu verbinden, wenn eine dem betreffenden Analogsignaleingang zugeordnete Adresse an den Adresseingang angelegt ist, und einem Analog/Digital-Wandler, dessen Eingang mit dem Ausgang des Multiplexers verbunden ist, um das jeweils an dem Ausgang ausgegebene Analogsignal zu digitalisieren.

### Stand der Technik

In der Praxis erweisen sich Schaltungsanordnungen zum Analog/Digital-Wandeln als fehleranfällig. Beispielsweise können Softwarefehler dazu führen, dass statt einer gewünschten Adresse eine falsche Adresse an den Adresseingang angelegt wird und dadurch statt eines gewünschten Analogsignals ein falsches Analogsignal gewandelt wird. Oder aber es treten innerhalb der Schaltungsanordnung Hardwarefehler wie defekte Leitungen auf. Aus diesen Gründen ist ein Überwachen von Schaltungsanordnungen zum Wandeln von Analogsignalen in Digitalsignale notwendig.

Aus der DE 196 31 972 C2 ist ein Verfahren zur Überwachung einer Schaltungsanordnung zum Analog/Digital-Wandeln bekannt. Dabei wird basierend auf einem zu digitalisierenden Analogsignal eine Folge von digitalen Impulsen generiert, von denen zumindest die Breite oder die Folgefrequenz analogsignalabhängig sind. Es wird anschließend überprüft, ob diese Impulsfolge und ein auf der Basis desselben Analogsignals durch die Schaltungsanordnung erzeugter Digitalwert einander entsprechen. Mit dem Verfahren lässt sich die Schaltungsanordnung zwar auf Hardwarefehler überprüfen, es erfolgt aber keine Überprüfung auf korrekte Adressierung eines von mehreren Analogsignaleingängen.

Verfahren, die eine Überprüfung einer Schaltungsanordnung zum Analog/Digital-Wandeln auf korrekte Adressierung ihrer Analogsignaleingänge erlauben, verwenden z. B. bekannte analoge Prüfsignale, die an die Analogsignaleingänge der Schaltungsanordnung zeitweilig anstelle von Nutzsignalen angelegt werden. Mit sequentiellem Anlegen der diesen Analogsignaleingängen zugeordneten Adressen an den Adresseingang werden die an den betreffenden Analogsignaleingängen anliegenden Prüfsignale von der Schaltungsanordnung nacheinander digitalisiert. Weil es sich bei den Prüfsignalen um bekannte Signale handelt, ist auch das Ergebnis von deren Wandlung an sich bekannt, so dass als Ergebnis der Wandlung eines jeweiligen Prüfsignals jeweils ein bestimmter digitaler Sollwert erwartet werden kann. Sofern das Ergebnis der Wandlung eines der Prüfsignale zu einem anderen als dem erwarteten Sollwert führt, wird dies als ein Hinweis auf eine Fehlerhaftigkeit der Schaltungsanordnung gewertet. Zum Ausführen einer solchen Überprüfung ist jedoch ein Umschalten der Schaltungsanordnung in einen Testmodus notwendig, in welchem die Prüfsignale anstelle der sonst zu wandelnden Nutzsignale an den Eingängen der Schaltungsanordnung anliegen, so dass das Wandeln der Nutzsignale unterbrochen werden muss, während die Schaltungsanordnung die Überprüfung durchführt. Insbesondere aus diesem Grund können wiederholte Überprüfungen meist auch nicht in kurzen Zeitintervallen, sondern nur mit relativ großen zeitlichen Abständen zwischen den einzelnen Überprüfungen ausgeführt werden. Des weiteren besteht bei einer solchen Schaltungsanordnung die Möglichkeit, dass ein Fehler diagnostiziert wird, obwohl die Wandlung der Nutzsignale korrekt abläuft, nur weil die Umschaltung auf die Prüfsignale gestört ist.

Eine Möglichkeit zur Behebung dieses Problems besteht darin, parallel zur zu überwachenden Schaltungsanordnung eine mehr oder weniger identische Schaltungsanordnung vorzusehen, wobei jeweils beide Anordnungen dasselbe Analogsignal wandeln und jeweilige von den beiden Anordnungen erzeugte Digitalsignale miteinander verglichen werden. Die praktische Realisierung einer derartigen Überwachung mit zwei Schaltungsanordnungen erfordert aber den doppelten technischen Aufwand und ist dementsprechend teuer. Zudem läuft eine solche Lösung dem allgemeinen Trend zur Miniaturisierung von Schaltungen zuwider.

### Vorteile der Erfindung

Durch die vorliegende Erfindung wird eine Schaltungsanordnung gemäß dem Oberbegriff des Anspruches 1 derart weitergebildet, dass auf einfache Art und Weise eine Überwachung dieser Schaltungsanordnung auf Fehler bei der Adressierung der Analogsignaleingänge und auf Hardwarefehler ermöglicht wird.

Weil erfindungsgemäß die vorgegebenen Prüfsignale jeweils solchen Analogsignaleingängen fest zugeordnet sind, bei deren Adressen ein einzelnes Bit den ersten Bitwert annimmt und alle anderen Bits den zweiten Bitwert annehmen, können die am Adresseingang anliegenden Adressen Bit für Bit darauf überprüft werden, ob die Bits korrekt jeden Binärwert annehmen. Wenn dies sichergestellt ist, kann mit Gewissheit davon ausgegangen werden, dass auch Adressen, bei denen keine oder zwei oder mehr Bits den zweiten Binärwert haben, korrekt am Adresseingang anliegen werden. Es können daher die Analogsignaleingänge, deren Adresse ein Bit mit dem ersten Bitwert enthält, dauerhaft mit den Prüfsignalen und die anderen Analogsignaleingänge dauerhaft mit den Nutzsignalen beaufschlagt sein; es besteht keine Notwendigkeit, einen Analogsignaleingang wahlweise mit einem Nutzsignal oder mit einem Prüfsignal beaufschlagen zu können.

Vorzugsweise ist die Zahl der mit einem Prüfsignal beschalteten Eingänge des Multiplexers gleich der Bitzahl von dessen Adresseingang, so dass jedes einzelne Bit des Adresseingangs einzeln prüfbar ist.

Zu wandelnde Nutzsignale, bei denen es sich wie bei den Prüfsignalen um Analogsignale handelt, werden vorzugsweise an Eingängen mit solchen Adressen vorgesehen, bei denen mindestens zwei Bits den ersten Bitwert annehmen.

Wenn der Analogsignaleingang eines Prüfsignals adressiert und dieses Prüfsignal daraufhin digitalisiert wird, liefert es einen digitalen Wert, der sich mit einem erwarteten digitalen Sollwert vergleichen lässt. Stimmen diese beiden Werte innerhalb vorgegebener Grenzen überein, kann die Schaltungsanordnung zum einen als frei von Hardwarefehlem erkannt werden. Zum anderen kann die Adressierung des Analogsignaleingangs dieses Prüfsignals als korrekt erkannt werden. Weil bei der diesem Analogsignaleingang zugeordneten Adresse ein Bit den ersten Bitwert annimmt und alle anderen Bits den zweiten Bitwert annehmen, kann daraus weiter geschlossen werden, das in der Schaltungsanordnung dieses den ersten Bitwert annehmende Bit den ersten Bitwert korrekt annehmen kann und dass die anderen Bits den zweiten Bitwert korrekt annehmen können.

Wenn nun die Adressierung aller mit Prüfsignalen belegter Analogsignaleingänge auf diese Weise durchgetestet wird und dabei kein Fehler entdeckt wird, so bedeutet dies, weil die Zahl der mit einem Prüfsignal beschalteten Analogsignaleingänge gleich der Bitzahl von dessen Adresseingang ist, dass in der Schaltungsanordnung alle Adressbits sowohl den ersten als auch den zweiten Bitwert korrekt annehmen können. Das bedeutet aber insbesondere, dass auch bei der Adresse eines beliebigen Analogsignaleingangs, an dem ein Nutzsignal anliegt, also einer Adresse, bei der mehr als ein Bit den ersten Bitwert annimmt, diese Bits in der Schaltungsanordnung den ersten Bitwert korrekt annehmen können und die jeweiligen anderen Bits dieser Adresse den zweiten Bitwert ebenfalls korrekt annehmen können. Weil dies der Fall ist, muss daher die Adressierung dieses Analogsignaleingangs innerhalb der Schaltungsanordnung korrekt erfolgen.

Besonders bevorzugt umfasst die Schaltungsanordnung als Prüfsignalquelle einen Spannungsteiler zum Abgreifen von Teilspannungen einer Betriebsspannung der Schaltungsanordnung als Prüfsignale. Damit können die Prüfsignale besonders einfach erzeugt werden. Besonders bevorzugt ist jeder ein Prüfsignal liefernde Ausgang der Prüfsignalquelle fest mit einem entsprechenden Analogsignaleingang des Multiplexers verdrahtet. Diese Analogsignaleingänge sind aus der Schaltungsanordnung nicht herausgeführt, so dass die von der Schaltungsanordnung zu wandelnden analogen Nutzsignale von außen nur noch an den übrigen Analogsignaleingängen des Multiplexers anlegbar sind. Ein irrtümliches Anlegen eines Nutzsignals an einen Analogsignaleingang, der eigentlich für ein Prüfsignal vorgesehen ist, was zu einem fehlerhaften Betrieb der Schaltungsanordnung führen würde, ist somit ausgeschlossen.

Ganz besonders bevorzugt liefern die an jeweils verschiedenen Analogsignaleingängen der Teilmenge anliegenden Prüfsignale unterschiedliche Ergebnisse der Digitalisierung in dem Analog/Digital-Wandler. Sofern die Prüfsignale als Teilspannungen von einem Spannungsteiler abgegriffen werden, dann werden diese Teilspannungen jeweils verschieden groß gewählt, so dass die Digitalisierung jedes Prüfsignals ein jeweiliges eindeutig zuzuordnendes Ergebnis liefert. Vertauschungen von Bits in der an den Multiplexer angelegten Adresse können dann daran erkannt werden, dass das Ergebnis der Wandlung dem Wandlungs-Sollwert eines nicht adressierten Prüfsignals entspricht.

Ein Komparator, von dem ein erster Eingang mit einem Ausgang des Analog/Digital-Wandlers verbunden ist, ermöglicht den Vergleich von Ergebnissen der Digitalisierung eines Prüfsignals mit einem vorgegebenen digitalen Sollwert, indem das Ergebnis der Digitalisierung des Prüfsignals durch den Analog/Digital-Wandler an diesen ersten Eingang des Komparators und der Sollwert an einen zweiten Eingang des Komparators angelegt wird. Sofern der Komparator eine Differenz zwischen dem Ergebnis der Digitalisierung des Prüfsignals und dem diesem Prüfsignal zugeordneten Sollwert feststellt, ist dies ein Hinweis darauf, dass entweder bei der Adressierung des Analogsignaleinganges dieses Prüfsignals oder in der Verbindungsleitung zwischen Multiplexer und Analog/Digital-Wandler ein Fehler vorliegt.

Ein solcher Fehler kann dann als Fehlereintrag in einem Fehlerregister, das in der Schaltungsanordnung vorgesehen sein kann, vermerkt werden. Auf dieses Fehlerregister können beispielsweise externe Steuerschaltungen zugriffsberechtigt sein, die ein die Schaltungsanordnung umfassendes Gerät steuern, so dass diese Steuerung anhand der Fehlereinträge entsprechend reagieren kann. Dabei kann der Fehlereintrag beispielsweise erst dann erfolgen, wenn die Differenz eine von Null verschiedene vorgegebene Grenze überschreitet, um eventuelle Wandlungstoleranzen aufgrund von elektronischem Rauschen innerhalb der Schaltungsanordnung zu berücksichtigen.

Bevorzugterweise ist die Schaltungsanordnung eingerichtet, die an den Analogsignaleingängen des Multiplexers anliegenden Analogsignale sequentiell und/oder zyklisch zu wandeln. Bei sequentiellem Wandeln wird gewährleistet, dass jedes der an einem der Analogsignaleingänge anliegenden Analogsignale, d.h. sowohl die Nutzsignale als auch die Prüfsignale, nacheinander gewandelt und eine Überprüfung der Schaltungsanordnung zumindest einmal, bevorzugt aber zu Beginn von dessen Betrieb, stattfindet, während beim zyklischen Wandeln eine solche Überprüfung permanent parallel zum Betrieb der Schaltungsanordnung stattfindet.

Bevorzugt umfasst die Schaltungsanordnung einen Speicher mit den Analogsignaleingängen des Multiplexers zugeordneten Speicherplätzen zum Speichern des Ergebnisses der Digitalisierung eines der Analogsignale durch den Analog/Digital-Wandler in einem jeweiligen der Speicherplätze, wobei die Schaltungsanordnung eingerichtet ist festzustellen, wenn einer der aus den Prüfsignalen erzeugten Digitalwerte aus dem Speicher ausgelesen wird, und diesen ausgelesenen Digitalwert im jeweiligen Speicherplatz durch einen jeweiligen vorgegebenen Digitalwert zu ersetzen. Vorteilhafterweise sind die vorgegebenen Digitalwerte von einer Größe, die von den gewandelten Prüfsignalen nicht erreicht wird, so dass sie in den Speicherplätzen von einem als Wandelergebnis erhaltenen Digitalwert eindeutig unterschieden werden können. Dadurch kann ein Ausfall einer Ablaufsteuerung für die Schaltungsanordnung daran erkannt werden, dass eines der vorgegebenen Digitalsignale in seinem jeweiligen Speicherplatz unverändert bleibt und insbesondere nicht durch eine neuerliche Wandlung des diesem Speicherplatz zugeordneten Prüfsignals im Speicherplatz ersetzt wird. Der vorgegebene Digitalwert kann Null sein, d.h. der Speicherplatz wird nach Auslesen des vom Analog/Digital-Wandler erzeugten Digitalwerts gelöscht und verbleibt im gelöschten Zustand, bis das entsprechende Prüfsignal neuerlich gewandelt wird.

Vorteilhafterweise ist zwischen dem Ausgang des Multiplexers und dem Eingang des Analog/Digital-Wandlers eine Referenzspannungsquelle zum Liefern einer Referenzspannung an den Eingang des Analog/Digital-Wandlers vorgesehen. Als Referenzspannung wird dann eine Spannung gewählt, die weder von den Prüfsignalen noch von einem der Nutzsignale erreicht wird. Außerdem wird als Innenwiderstand der Referenzspannungsquelle ein Widerstand gewählt, der vielfach höher ist als die Innenwiderstände von Signalquellen, denen die Analogsignale entstammen, der also insbesondere auch höher als der Innenwiderstand der Prüfsignalquelle ist. Die an den Eingang des Analog/Digital-Wandlers angelegte Referenzspannung wird dem jeweiligen in den Analog/Digital-Wandler eingegebenen Analogsignal, unbeachtlich ob Nutzsignal oder Prüfsignal, als Störsignal überlagert. Weil der Innenwiderstand der Referenzspannungsquelle jedoch relativ zu Innenwiderständen der Signalquellen für die Analogsignale sehr groß gewählt ist, hat diese Überlagerung keinen merklichen Einfluss auf das Ergebnis der Digitalisierung. Erst bei Auftreten einer defekten Leitung derart, dass das Analogsignal entfällt und die Referenzspannung allein am Analog/Digital-Wandler anliegt, erhält man als Ergebnis der Wandlung einen für diese Referenzspannung typischen Wert. Anhand des Auftretens dieses Wertes kann ein Hardwarefehler in der Schaltungsanordnung unabhängig davon erkannt werden, ob der Multiplexer gerade ein Nutzsignal oder ein Prüfsignal an den Ausgang ausgibt.

Bei einer dazu alternativen Ausgestaltung der Schaltungsanordnung ist ein Schalter vorgesehen, mit dem die von der Referenzspannungsquelle gelieferte Referenzspannung wahlweise an den Eingang des Analog/Digital-Wandlers angelegt werden kann.

An dem Multiplexer kann ein unbeschalteter Analogsignaleingang vorgesehen sein, d.h. ein Eingang, an dem kein Analogsignal anliegt. Dem unbeschalteten Analogsignaleingang ist vorzugsweise diejenige Adresse zugeordnet, bei der alle Bits den zweiten Bitwert annehmen. Wenn mit dem Schalter die Referenzspannung an den Eingang des Analog/Digital-Wandlers angelegt wird, wird gleichzeitig die Adresse dieses unbeschalteten Analogsignaleingangs an den Adresseingang des Multiplexers angelegt. Vom Multiplexer wird daher kein Analogsignal am Ausgang ausgegeben, und der Analog/Digital-Wandler empfängt allein die Referenzspannung zum Wandeln. Weil bei dieser Ausgestaltung die Referenzspannung stets an den Eingang des Analog/Digital-Wandlers angelegt wird, ohne mit einem vom Multiplexer ausgegebenen Analogsignal zu überlagern, ist auch die Größe des Innenwiderstandes der Referenzspannungsquelle bei dieser Ausgestaltung unbeachtlich. Wenn nach Digitalisieren der Referenzspannung der für diese Spannung erwartete Sollwert erhalten wird, so ist damit die fehlerfreie Funktion des Analog/Digital-Wandlers festgestellt.

Weitere Merkmale und Vorteile der Erfindung ergeben sich aus der nachfolgenden Beschreibung eines Ausführungsbeispiels, bei dem auf die beigefügten Figuren Bezug genommen wird. Es zeigen:
- Fig. 1: eine erfmdungsgemäße Schaltungsanordnung; und
- Fig. 2: eine Tabelle, in der die einzelnen Eingänge des Multiplexers mit den ihnen zugewiesenen Bitadressen aufgeführt sind.

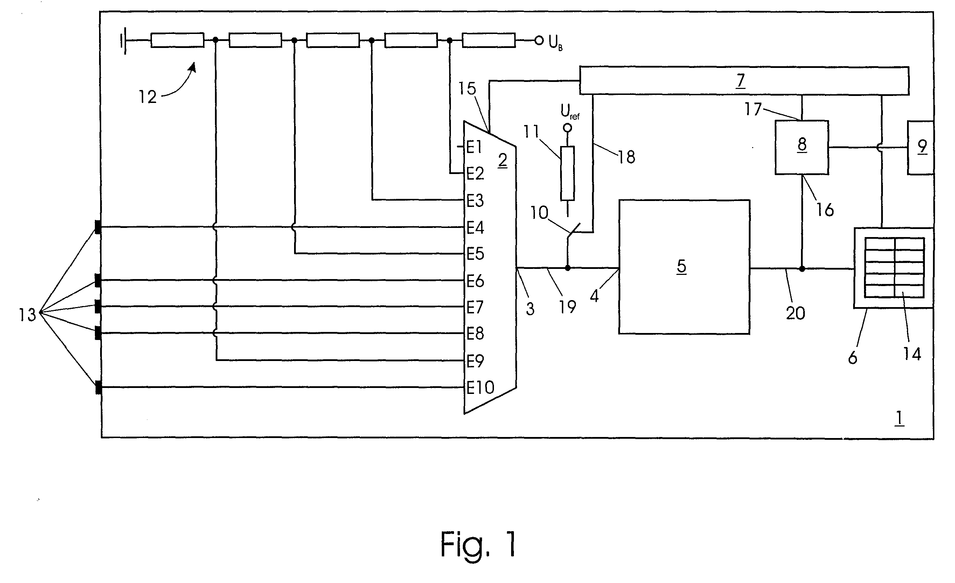

In Fig. 1 ist ein Beispiel für eine erfindungsgemäße Schaltungsanordnung gezeigt, die auf einer Leiterplatte 1 aufgebaut ist. Zur Schaltungsanordnung gehört unter anderem ein Multiplexer 2 mit zehn Analogsignaleingängen E1-E10. Über einen vier Bit breiten Adresseingang 15 sind die Analogsignaleingänge E1-E10 von einer Kontrolllogik 7 adressierbar, indem diese eine dem betreffenden Analogsignaleingang E1-E10 zugeordnete Adresse mit vier Bits an den Adresseingang 15 anlegt. Ein Ausgang 3 des Multiplexers 2 steht mit einem Eingang 4 eines Analog/Digital-Wandlers 5 über eine Leitung 19 in Verbindung, und der Analog/Digital-Wandler 5 ist ausgangsseitig wiederum mit einem Speicher 6 verbunden. Der Speicher 6 weist zehn verschiedene Speicherplätze 14 auf, von denen jeder einem der Analogsignaleingänge E1-E10 eindeutig zugeordnet ist. Die Kontrolllogik 7 ist mit dem Speicher 6 steuernd verbunden. Ein erster Eingang 16 eines Komparators 8 ist mit einer Verbindungsleitung 20 zwischen dem Analog/Digital-Wandler 5 und dem Speicher 6 verbunden. Außerdem ist ein zweiter Eingang 17 des Komparators 8 mit der Kontrolllogik 7 verbunden. Ausgangsseitig ist der Komparator 8 mit einem Fehlerregister 9 verbunden. Eine Steuerleitung 18 führt von der Kontrolllogik 7 zu einem Schalter 10, mit dem die Kontrolllogik 7 wahlweise eine Referenzspannungsquelle mit einem Innenwiderstand 11, die eine Referenzspannung U_{ref} liefert, mit der Leitung 19 zwischen dem Ausgang 3 des Multiplexers 2 und dem Eingang 4 des Analog/Digital-Wandlers 5 verbinden kann.

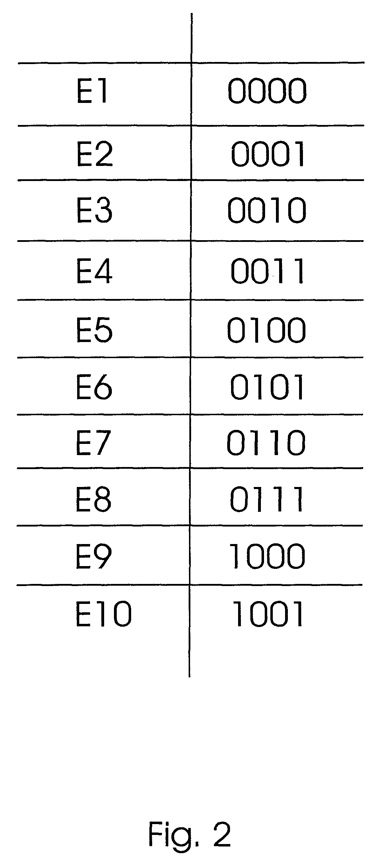

In der Tabelle der Fig. 2 ist die Zuordnung zwischen den Analogsignaleingängen E1-E10 und den vier Bit breiten Adressen gezeigt. Wie man der Tabelle der Fig. 2 entnehmen kann, ist den Analogsignaleingängen E2, E3, E5 und E9 gemeinsam, dass bei deren Adressen jeweils drei Bits den Bitwert 0 annehmen und jeweils nur ein Bit den Bitwert 1 annimmt.

Wie nun aus der Fig. 1 gesehen werden kann, sind diese Analogsignaleingänge E2, E3, E5 und E9 mit einem Spannungsteiler 12 fest verbunden. Der Spannungsteiler 12 teilt eine Betriebsspannung U_{B} der Schaltungsanordnung in vier jeweils unterschiedliche Teilspannungen, so dass jeder der Analogsignaleingänge E2, E3, E5 und E9 jeweils eine andere dieser Teilspannungen als ein analoges Prüfsignal empfängt. Dagegen sind die Analogsignaleingänge E4, E6, E7, E8 und E10 jeweils mit externen Anschlüssen 13 der Schaltungsanordnung verbunden, über die jeweils ein analoges Nutzsignal in die Schaltungsanordnung eingebbar ist. Der Analogsignaleingang E1, dem die Adresse 0000 zugeordnet ist, ist unbeschaltet.

Adressiert die Kontrolllogik 7 einen der Analogsignaleingänge Ei (wobei i=2,...,10) unter den Analogsignaleingängen E2-E10, dann wird das am Analogsignaleingang Ei anliegende Analogsignal, das im Falle der Eingänge E4, E6, E7, E8 und E10 ein Nutzsignal und im Falle der Eingänge E2, E3, E5 und E9 ein Prüfsignal ist, vom Multiplexer 2 durchgelassen, gelangt über dessen Ausgang 3 zum Eingang 4 des Analog/Digital-Wandlers 5, wird von diesem in einen Digitalwert gewandelt, und dieser Digitalwert wird vom Analog/Digital-Wandler 5 in den Speicher 6 ausgegeben, wo es in dem jeweiligen, dem Analogsignaleingang Ei eindeutig zugeordneten Speicherplatz 14 gespeichert wird.

Weil die an den Analogsignaleingängen E2 E3, E5 und E9 als Prüfsignale anliegenden Teilspannungen jeweils vorgegebene bekannte Pegel haben, sind auch die bei korrekter Wandlung dieser Teilspannungen erhaltenen Digitalwerte vorbekannt. Die Kenntnis der erwarteten Digitalwerte für diese Teilspannungen bei fehlerfreier Funktion der Schaltungsanordnung wird von der Kontrolllogik 7 für die Funktionsüberprüfung der Schaltungsanordnung ausgenutzt. Hierzu legt die Kontrolllogik 7 z. B. den bei Wandeln der am Analogsignaleingang E5 anliegenden Teilspannung als Ergebnis erwarteten digitalen Sollwert an den mit ihr verbundenen zweiten Eingang 17 des Komparators 8 an, während das nach Wandeln dieser Teilspannung tatsächlich erhaltene Digitalisierungsergebnis über den ersten Eingang 16 des Komparators 8, der mit der Verbindungsleitung 20 zwischen Analog/Digital-Wandler 5 und Speicher 6 verbunden ist, in den Komparator 8 gelangt. Vom Komparator 8 werden der von der Kontrolllogik 7 an ihn angelegte erwartete digitale Sollwert und das vom Analog/Digital-Wandler 5 tatsächlich gelieferte Digitalisierungsergebnis miteinander verglichen. Sofern diese übereinstimmen oder eine Differenz zwischen ihnen innerhalb einer vorgegebenen Grenze bleibt, erfolgt keine Reaktion des Komparators 8. Sobald die beiden Werte aber voneinander verschieden sind, bzw. wenn eine Differenz zwischen beiden die vorgegebene Grenze überschreitet, erfolgt durch den Komparator 8 eine entsprechende Fehlermeldung in das Fehlerregister 9. Optional kann die Fehlermeldung auch an die Kontrolllogik 7 erfolgen. Die im Fehlerregister 9 enthaltene Fehlermeldung kann beispielsweise von externen, der gezeigten erfindungsgemäßen Schaltungsanordnung nachfolgenden Schaltungen ausgelesen und ausgewertet werden.

Bei einer ersten Ausgestaltung eines Betriebsverfahrens für die erfindungsgemäße Schaltungsanordnung adressiert die Kontrolllogik 7 bei jeder Inbetriebnahme der Schaltungsanordnung bzw. eines Geräts, in das sie eingebaut ist, alle Analogsignaleingänge E2-E10 der Reihe nach, so dass die an diesen Analogsignaleingängen E2-E10 anliegenden Nutzsignale und Prüfsignale bzw. Teilspannungen sequentiell vom Analog/Digital-Wandler 5 in Digitalwerte gewandelt und in den jeweiligen Speicherplätzen 14 des Speichers 6 gespeichert werden und eventuelle Fehler im Fehlerregister 9 vermerkt werden.

Einer zweiten Ausgestaltung des Betriebsverfahrens zufolge adressiert die Kontrolllogik 7 während des Betriebs der Schaltungsanordnung bzw. während des Betriebs eines Geräts, das die Schaltungsanordnung umfasst, zyklisch alle Analogsignaleingänge E2-E10. Weil bei der zyklischen Wiederholung des Wandelns der an den Analogsignaleingängen E2-E10 anliegenden Signale stets auch die an den Analogsignaleingängen E2, E3, E5 und E9 anliegenden Teilspannungen oder Prüfsignale gewandelt werden und im Falle eines Fehlers ein Eintrag in das Fehlerregister 9 erfolgt, ist damit auf einfache Weise eine Funktionsüberprüfung der Schaltungsanordnung parallel zum Betrieb der Schaltungsanordnung implementiert, ohne dass der Betrieb der Schaltungsanordnung für die Überprüfung derselben unterbrochen oder eingeschränkt werden müsste.

Sofern der Verdacht auf Fehlfunktion bei der Adressierung eines bestimmten der Analogsignaleingänge E2-E10 oder auf Unterbrechung der Verbindungsleitung 19 zwischen dem Multiplexer 2 und dem Analog/Digital-Wandler 5 besteht, kann die Kontrolllogik 7, beispielsweise auf Anfrage von externen Schaltungen, auch ohne größeren Aufwand eine gezielte Funktionsüberprüfung veranlassen. Besteht z. B. der Verdacht, dass die Adressierung des Einganges E6 mit der Adresse 0101 fehlerhaft ist, so kann die Kontrolllogik 7 die Adressierung dieses Einganges E6 mittels der an den Eingängen E2 und E5 anliegenden Teilspannungen gezielt überprüfen: Die Kontrolllogik adressiert den Analogsignaleingang E2 mit der Bitadresse 0001 und überprüft auf die oben beschriebene Weise die Korrektheit der Wandlung der am Analogsignaleingang E2 anliegenden Teilspannung. Erfolgt diese Wandlung erwartungsgemäß, so ist sichergestellt, dass in der Schaltungsanordnung bei Adressierungen das Bit mit Stellenwert Eins den Bitwert 1, und die Bits mit den Stellenwerten 3, 4 und 8 den Bitwert 0 korrekt annehmen können. Entsprechend führt die Kontrolllogik 7 eine Überprüfung der Wandlung der am Analogsignaleingang E5 anliegenden Teilspannung durch. Weil dem Eingang E5 die Bitadresse 0100 zugewiesen ist, ist bei korrekter Wandlung der am Analogsignaleingang E5 anliegenden Teilspannung sichergestellt, dass in der Schaltungsanordnung bei Adressierungen das Bit mit Stellenwert Vier den Bitwert 1 und die Bits mit Stellenwert Eins, Zwei bzw. Acht den Bitwert 0 korrekt annehmen können. Weil in der Bitadresse des Analogsignaleinganges E6 das Bit mit Stellenwert Eins und das Bit mit Stellenwert Vier den Bitwert 1 annehmen, kann bei Ausbleiben einer Fehlermeldung im Fehlerregister 9 bzw. an die Kontrolllogik 7 nach Überprüfen der Adressierung der Analogsignaleingänge E1 und E5 auf die korrekte Adressierung des Analogsignaleingangs E6 geschlossen werden.

Die Kontrolllogik 7 ist bei der zweiten Ausgestaltung des Betriebsverfahrens für die Schaltungsanordnung ferner eingerichtet, festzustellen, wenn in den Speicherplätzen 14 des Speichers 6 gespeicherte Digitalisierungsergebnisse ausgelesen werden. Wenn Digitalisierungsergebnisse aus Speicherplätzen 14, die den Analogsignaleingängen E2, E3, E5 und E9 zugewiesen sind, ausgelesen werden, dann wird der entsprechende Speicherplatz 14 nach Auslesen des Digitalisierungsergebnisses auf Null gesetzt.

Die den Analogsignaleingängen E4, E6, E7, E8 und E10 zugewiesenen Speicherplätze 14 des Speichers 6, in denen die nach Wandeln der an diesen Eingängen anliegenden Nutzsignale erhaltenen Digitalisierungsergebnisse gespeichert werden, werden dagegen nach Auslesen nicht gelöscht, damit diese Daten auch nach eventuell eintretenden Datenverlusten in nachfolgenden Schaltungen, die auf diese Daten angewiesen sind, noch verfügbar sind und neuerlich ausgelesen werden können.

Weil die den Analogsignaleingängen E2, E3, E5 und E9 zugewiesenen Speicherplätze 14 des Speichers 6 nach Auslesen der darin enthaltenen Digitalisierungsergebnisse auf einen bekannten Wert gesetzt bzw. gelöscht werden, ist es möglich, das Eintreten eines Fehlers in einer von der Kontrolllogik 7 ausgeübten Ablaufsteuerung für die Schaltungsanordnung zu erkennen, wenn sich die in diesen Speicherplätzen 14 enthaltenen vorgegebenen Werte während des Betriebs der Schaltungsanordnung nicht mehr ändern.

Schließlich kann die Kontrolllogik 7 zur Überprüfung der Funktion des Analog/Digital-Wandlers 5 durch Umlegen des Schalters 10 die Referenzspannung U_{ref} mit dem Innenwiderstand 11 an dessen Eingang 4 anlegen, während sie an den Adresseingang 15 des Multiplexers 2 die dem unbeschalteten Analogsignaleingang E1 zugewiesene Adresse 0000 anlegt, so dass der Ausgang des Multiplexers 2 schwebt. Dann ist der Pegel am Eingang 4 des Analog/Digital-Wandlers 5 ausschließlich durch die Referenzspannung U_{ref} gegeben. Weil die Referenzspannung U_{ref} bekannt ist, ist auch das bei korrekter Wandlung vom Analog/Digital-Wandler 5 erzeugte Ergebnis der Digitalisierung für diese Referenzspannung U_{ref} bekannt. Mit Hilfe des Komparators 8 lässt sich analog zur oben beschriebenen Art und Weise das tatsächlich erhaltene Ergebnis der Digitalisierung der Referenzspannung U_{ref} mit dem bei korrekter Wandlung erwarteten Ergebnis vergleichen und bei Abweichungen zwischen diesen beiden auf einen Fehler des Analog/Digital-Wandlers 5 oder der Leitung zwischen dem Schalter 10 und dem Eingang 4 des Wandlers schließen. In einem solchen Fall wird wieder eine entsprechende Fehlermeldung im Fehlerregister 9 abgelegt. Diese Überprüfung der Funktion des Wandlers 5 wird von der Kontrolllogik 7 insbesondere dann durchgeführt, wenn bei einer vorhergehenden Wandlung der Prüfsignale bei mehreren Prüfsignalen vom jeweiligen Sollwert abweichende Digitalisierungsergebnisse erhalten wurden.

## Patentansprüche

1. Schaltungsanordnung zum Wandeln von Analogsignalen in Digitalsignale, mit einem Multiplexer (2), der eine Mehrzahl von Analogsignaleingängen(E1-E10), einen mehrere Bit breiten Adresseingang (15) und einen Ausgang (3) aufweist und eingerichtet ist, einen der Analogsignaleingänge mit dem Ausgang (3) zu verbinden, wenn eine dem betreffenden Analogsignaleingang zugeordnete Adresse an den Adresseingang (15) angelegt ist, und einem Analog/Digital-Wandler (5), dessen Eingang (4) mit dem Ausgang (3) des Multiplexers (2) verbunden ist, um das jeweils an dem Ausgang (3) ausgegebene Analogsignal zu digitalisieren, **dadurch gekennzeichnet, dass** sie wenigstens eine Prüfsignalquelle (12) zum Liefern eines Prüfsignals an eine Teilmenge (E2, E3, E5, E9) der Analogsignaleingänge (E1-E10) des Multiplexers (2) umfasst, und dass den Analogsignaleingängen (E2, E3, E5, E9) dieser Teilmenge jeweils eine Adresse zugeordnet ist, von deren Bits eines einen ersten Binärwert hat und alle anderen einen von dem ersten verschiedenen zweiten Binärwert haben.

2. Schaltungsanordnung nach einem der vorhergehenden Ansprüche, **dadurch gekennzeichnet, dass** die Prüfsignalquelle einen Spannungsteiler (12) zum Abgreifen einer Teilspannung einer Betriebsspannung der Schaltungsanordnung als Prüfsignal aufweist.

3. Schaltungsanordnung nach einem der vorhergehenden Ansprüche, **dadurch gekennzeichnet, dass** jeder ein Prüfsignal liefernde Ausgang der Prüfsignalquelle fest mit einem entsprechenden Analogsignaleingang der Teilmenge (E2, E3, E5, E9) verdrahtet ist.

4. Schaltungsanordnung nach einem der vorhergehenden Ansprüche, **dadurch gekennzeichnet, dass** die an jeweils verschiedenen Analogsignaleingängen der Teilmenge (E2, E3, E5, E9) anliegenden Prüfsignale unterschiedliche Ergebnisse der Digitalisierung in dem Analog/Digital-Wandler (5) liefern.

5. Schaltungsanordnung nach einem der vorhergehenden Ansprüche, **gekennzeichnet durch** einen Komparator (8), von dem ein erster Eingang (16) mit einem Ausgang des Analog/Digital-Wandlers (5) verbunden ist.

6. Schaltungsanordnung nach Anspruch 5, **gekennzeichnet durch** einen Sollwertgeber (7) zum Liefern eines Sollwerts für das Ergebnis der Digitalisierung eines Prüfsignals **durch** den Analog/Digital-Wandler (5) an einen zweiten Eingang (17) des Komparators (8).

7. Schaltungsanordnung nach Anspruch 5 oder 6, **gekennzeichnet durch** ein Fehlerregister (9), in das ein Fehlereintrag erfolgt, wenn der Komparator (8) eine Differenz zwischen einem Ergebnis der Digitalisierung eines Prüfsignals und einem diesem Prüfsignal zugeordneten Sollwerts feststellt.

8. Schaltungsanordnung nach Anspruch 7, **dadurch gekennzeichnet, dass** der Fehlereintrag erfolgt, wenn die Differenz eine von Null verschiedene vorgegebene Grenze überschreitet.

9. Schaltungsanordnung nach einem der vorhergehenden Ansprüche, **dadurch gekennzeichnet, dass** die Schaltungsanordnung eingerichtet ist, die an den Eingängen (E2-E10) des Multiplexers (2) anliegenden Analogsignale sequentiell und/oder zyklisch zu wandeln.

10. Schaltungsanordnung nach Anspruch 9, **gekennzeichnet durch** einen Speicher (6) mit den Eingängen (E1-E10) des Mehrfachwandlers (2) zugeordneten Speicherplätzen (14) zum Speichern des Ergebnisses der Digitalisierung eines der Analogsignale **durch** den Analog/Digital-Wandler (5) in dem jeweils zugeorneten Speicherplatz (14), wobei die Schaltungsanordnung eingerichtet ist festzustellen, wenn einer der aus den Prüfsignalen erzeugten Digitalwerte aus dem Speicher (6) ausgelesen wird, und diesen ausgelesenen Digitalwert im jeweiligen Speicherplatz (14) **durch** einen jeweils vorgegebenen Digitalwert zu ersetzen.

11. Schaltungsanordnung nach einem der vorhergehenden Ansprüche, **gekennzeichnet durch** eine Referenzspannungsquelle zwischen dem Ausgang (3) des Multiplexers (2) und dem Eingang (4) des Analog/Digital-Wandlers (5) zum Liefern einer Referenzspannung an den Eingang (4) des Analog/Digital-Wandlers (5).
